Europäisches Patentamt

(19) European Patent Office

Office européen des brevets

(11) Veröffentlichungsnummer: **0 172 518**
**A2**

(12) # EUROPÄISCHE PATENTANMELDUNG

(21) Anmeldenummer: 85110093.3

(51) Int. Cl.⁴: **H 01 B 1/12**

(22) Anmeldetag: 12.08.85

(30) Priorität: 24.08.84 DE 3431132

(43) Veröffentlichungstag der Anmeldung:
26.02.86 Patentblatt 86/9

(84) Benannte Vertragsstaaten:
BE DE FR GB NL

(71) Anmelder: BASF Aktiengesellschaft
Carl-Bosch-Strasse 38
D-6700 Ludwigshafen(DE)

(72) Erfinder: Moehwald, Helmut
Sandwingert 53
D-6900 Heidelberg(DE)

(72) Erfinder: Muenstedt, Helmut, Dr.
An dem Altenbach 41
D-6706 Wachenheim(DE)

(54) Verfahren zur Herstellung von Verbundstoffen aus nichtleitenden und intrinsisch leitfähigen Polymeren.

(57) Es wird ein Verfahren zur Herstellung von Verbundstoffen aus nichtleitenden Polymeren und intrinsisch leitfähigen Polymeren mit einem leitfähigen Stoff beschichtet oder ein nichtleitendes Polymeres verwendet, das in feinteiliger Form einen leitfähigen Stoff enthält und bei dem man diese so ausgerüsteten Formkörper in eine Lösung taucht, die außer einem anodisch oxidierbaren und polymerisierbaren Monomeren ein Leitsalz enthält, den Formkörper als Anode schaltet und das Monomere anodisch polymerisiert.

EP 0 172 518 A2

Croydon Printing Company Ltd.

Verfahren zur Herstellung von Verbundstoffen aus nichtleitenden und
intrinsisch leitfähigen Polymeren

Die Erfindung betrifft ein Verfahren zur Herstellung von Verbundstoffen
aus nichtleitenden Polymeren und intrinsisch leitfähigen Polymeren.

Es ist bekannt, daß man elektrochemisch oxidierbare und polymerisierbare
Monomere wie z.B. Pyrrol oder Thiophen in Gegenwart von Leitsalzen in Lösungen elektrochemisch polymerisieren kann. Dabei scheidet sich das Polymere auf der Anode in Form eines zusammenhängenden Films ab. Es handelt
sich dabei um p-intrinsisch leitfähige Polymere, die die Anionen als
Leitsalze eingelagert enthalten. So wird z.B. die Herstellung von leitfähigen Pyrolpolymerisaten in der US-PS 3 574 072 beschrieben.

Für bestimmte Anwendungen von Formkörpern von elektrisch nicht leitfähigen Polymeren ist es erforderlich, die Oberfläche der Formkörper elektrisch leitend zu machen. Dies ist z.B. der Fall, wenn das Problem der
Ableitung elektrostatischer Aufladungen an Gehäusen für elektromagnetische Abschirmung zu bewerkstelligen ist. Dabei hat sich ein Verfahren,
vor allem·in die Technik eingeführt, bei dem man die nichtleitenden
Polymeren an ihrer Oberfläche galvanisch mit bestimmten Metallen überzieht. Diese Arbeitsweise bezeichnet man als Kunststoff-Galvanisieren.
Eine Beschreibung solcher Arbeiten findet sich in Angew. Chem. 82 (1970),
Seiten 412-417. Auch finden sich Angaben über das Galvanisieren von
Kunststoffen in Kirk-Othmer "Encyclopedia of Chemical Technology",
Volume 8, Seite 832, übergehend auf 833. Auch nichtleitende Kunststoffe,
die elektrochemisch galvanisiert werden, werden vor allem sog. ABS-Polymerisate, Polycarbonate oder Polysulfone verwendet. Aufgabenstellung ist
es, ein neues Verfahren zur Herstellung von Verbundstoffen aus nichtleitenden Polymeren aufzuzeigen von denen mindestens eine Oberflächenschicht mit einem intrinsisch leitfähigen Polymeren verbunden ist.

Die Aufgabe der Erfindung wird durch ein Verfahren zur Herstellung von
Verbundstoffen aus nichtleitenden Polymeren und intrinsisch leitfähigen
Monomeren gelöst, bei dem man die Oberfläche eines Formkörpers eines
nichtleitenden Polymeren mit einem leitfähigen Stoff beschichtet und/oder
einen Formkörper eines nichtleitenden Polymeren, das einen leitfähigen
Stoff in feinteiliger Form enthält, in eine Lösung eintaucht, die ein
anodisch-oxidierbares und polymerisierbares Monomeres und ein Leitsatz
enthält, den Formkörper als Anode schaltet und das Monomere anodisch polymerisiert.

vG/P

0172518

Die nach dem erfahrenen Verfahren erhaltenen Verbundstoffe haben mindestens eine Oberfläche, die intrinsisch elektrisch leitfähig ist. Die Leitfähigkeit entspricht der des aufpolymerisierten intrinsisch leitfähigen Polymeren. Derartige Formkörper können z.B. als Leiterbahnen für Abschirmzwecke verwendet werden. Die leitfähige Schicht kann auch dem Korrosionsschutz dienen. Es hat sich gezeigt, daß ein fester Verbund zwischen den nichtleitenden und intrinsisch leitenden Polymerschichten besteht, so daß man die Formkörper in thermoplastischem Zustand verformen kann.

Für das Verfahren eignen sich alle nichtleitenden Polymeren, die als thermoplastisch verarbeitbare Kunststoffe Verwendung finden. Diese nichtleitenden Polymeren haben im allgemeinen eine Leitfähigkeit zwischen $10^{-14}$ und $10^{-8}$ S/cm. Sie dienen daher auch als Isolierstoffe. Besonders geeignet sind für das Verfahren sog. ABS- und ASA-Polymeren, die aus einer Matrix eines Styrol-Acrylnitril-Polymerisates bestehen, in die eine Weichphase auf der Basis eines mit Styrol und Acrylnitril gepfropften Butadienpolymerisates (ABS) oder auf Basis eines mit Styrol und Acrylnitril gepfropften Acrylsäureesterpolymerisates (ASA) eingebettet ist. Für das Verfahren können aber auch andere nichtleitenden Polymeren, wie Polyamide, Polyester oder auch Polyolefine, wie Polypropylen oder Polyethylen verwendet werden. Weiterhin eignen sich Vinyl-Polymerisate oder fluor- und chlorenthaltende Polymeren. Die nichtleitenden Polymeren können in beliebiger Formgebung vorliegen. Zweckmäßig verwendet man jedoch Formkörper, deren Dicke im Verhältnis zur Längen- und Breitenausdehnung geringt ist. Besonders geeignet sind also Platten, Bahnen oder Folien der nichtleitfähigen Polymeren. Diese Formkörper können einseitig oder beidseitig mit dem leitfähigen Polymeren beschichtet werden, das ein Verbundstoff entsteht, entweder aus einer nichtleitenden oder leitfähigen Schicht oder aus zwei leitfähigen Schichten, in die die nichtleitende Schicht eingebettet ist.

Die nichtleitenden Polymeren werden vor den weiteren Verfahrensschritten mit einem leitfähigen Stoff beschichtet. Als leitfähige Stoffe kommen z.B. Metalle in Betracht. Es können aber auch Ruß oder Graphit verwendet werden. Weiterhin eignen sich anorganische Halbleiter, wie Silicium oder bestimmte Metalloxide. Die leitfähigen Stoffe werden in einer Schichtdicke von mindestens 0,01 µ aufgebracht. Meist ist es nicht erforderlich, die Schichtdicke größer als 1 µ zu halten. So kann man z.B. nach den bekannten Methoden Metalle, wie Kupfer oder Nickel aufdampfen. Man kann aber auch Metallsalze durch Reduktion auf die Oberfläche der nichtleitenden Polymeren abscheiden. So kann man z.B. Zinnchloride auf die Oberfläche aufbringen und diese danach mit Silbernitrat-Lösungen behandeln.

Auch eignet sich das Tauchen in Palladiumsalzlösungen und eine nachträgliche Behandlung mit Hydrazinhydrat oder Natriumtetrahydrodiborat. Geeignet ist auch das Eintauchen der Formkörper aus den nichtleitenden Kunststoffen in kolloidale Metallösungen. Bei bestimmten Kunststoffen, wie
z.B. ABS-Polymerisaten hat sich das Beizen mit edelmetallhaltiger Chromschwefelsäure besonders bewährt. Es ist ein Vorteil des Verfahrens der
vorliegenden Erfindung, daß man die Oberfläche auch mit feinteiligem Ruß
oder Graphit besprühen kann.

Vor dem Aufbringen der leitfähigen Schicht ist es zweckmäßig, die Oberfläche des Formkörpers aus den nichtleitenden Polymeren aufzurauhen. So
hat sich z.B. bei ABS-Polymerisaten das Beizen mit Chromschwefelsäure als
besonders geeignet erwiesen. Es entstehen dann an der Oberfläche Kavernen, in die sich das aufzubringende Polymere mechanisch verankern kann.
Man kann aber auch die Oberfläche nach Säuberung mechanisch aufrauhen, um
die Haftfestigkeit des Polymeren zu verbessern.

Anstelle der Formkörper aus nichtleitenden Polymeren, die mit einem leitfähigen Stoff beschichtet sind, kann man auch solche Formkörper aus den
nichtleitenden Polymeren verwenden, in die feinteilige leitfähige Stoffe
eingebettet sind. So kann man z.B. Formkörper aus Polyolefinen und Ruß
oder Graphit, die etwa zwischen 10 bis 40 % des feinteiligen leitfähigen
Stoffes enthalten, und somit leitfähig sind, nach dem Verfahren der Erfindung mit einer Schicht aus einem intrinsisch leitfähigen Polymeren beschichten. Es ist aber auch möglich, Formkörper aus nichtleitfähigen
Kunststoff, die feinteilige Metalle eingelagert enthalten, oder feinteilige Halbleiter eingelagert enthalten, zu verwenden.

Die so leitfähig ausgerüsteten Formkörper werden in eine Lösung eingetaucht, die neben einem Leitsalz ein anodisch oxidierbares und poylmerisierbares Monomeres enthalten. Solche oxidierbaren und polymerisierbaren
Monomere sind z.B. solche, die ein heteroaromatisches Ringsystem enthalten, die auch Teil eines konjugierten  -Elektronensystems sein können.
Geeignet sind z.B. 5-Ring-Heterocyclen, z.B. Thiophen, Pyrrol, Furan,
Pyrazol, Imidazol, Thiazol, Oxazol. Diese fünf Ring-Heterocyclen können
durch Halogen, Alkyl, Carbalkoxy, Carbonyl oder Hydroxy-Gruppen substituiert sein. Auch kommen verknüpfte Heterocyclen wie Tetrathiafulvalen in
Frage. Besonders geeignet sind jedoch Verbindungen aus der Klasse der
Pyrrole und Thiophene. Andere anodisch polymerisierbare und oxidierbare
Monomere sind z.B. Anilin, Carbazol oder Indol.

Falls das Leitsalz im Monomeren löslich ist, wird der Formkörper in die
Lösung des Leitsatzes im Monomeren eingetaucht und polymerisiert. Meist

........ auch von Vorteil, das oder die Monomeren in einem Lösungsmittel zu ......., das zusammen mit dem Leitsatz den Elektrolyt bildet. Die Monomeren .... in Mengen von 0,1 bis 50 Gew.-Teilen, bezogen auf 100 Gew.-Teile .........mittel in der Lösung enthalten. Als Lösungsmittel eignen sich z.B. ....organische Lösungsmittel, wie Methanol, Ethanol, Polyole, Aceton, Tetra-.........furan. Es eignet sich aber auch Pyridin, Acetonitril, Methylen-........id, Eisessig, Propylencarbonat, Dimethyoxyether, Sulfolan oder .......ylsulfoxid. Es kann aber auch in Wasser oder in Mischungen von ........ mit einem der oben genannten mit Wasser mischbaren Lösungsmitteln .........itet werden. Die Verwendung von Wasser hat darüber hinaus den ......., daß keine Verformungen der nichtleitenden Kunststoffe vorkommen, .... es bei Verwendung organischer Lösungsmittel, die den Kunststoff ...quellen, der Fall sein kann. Aus diesem Grunde ist es erforderlich, die ......ungsmittel bzw. Lösungsmittelgemische so auszuwählen, daß es nicht zu .....em Anquellen und Verformung des Kunststoffs kommt.

....Lösungen enthalten zur Erhöhung der Leitfähigkeit einen Elektrolyten. ......zu eignen sich insbesondere die Alkali- oder Ammoniumsalze von $PF_6^-$, $ClO_4^-$, $PF_4^-$, $AsF_6^-$. Weiterhin kommen Anionen organischer Säuren, wie ......olsulfonsäure oder Toluolsulfonsäure oder Trifluorethansulfonsäure in .....ge. Besonders brauchbar ist z.B. bei Verwendung von Wasser oder Wasser ....haltenden Mischungen als Lösungsmittel Kochsalz. Die Leitsalze sind in ....Lösung in Mengen von 0,01 bis 1 molar enthalten. Die intrinsisch ....fähigen Polymeren werden durch elektrochemische Polymerisation der .....nnten Monomeren erhalten, wobei die Polymerisation durch anodische ......dation erfolgt. Es werden hierzu beispielsweise Stromdichten von 0,01 ....20 $mA/cm^2$ verwendet. Es werden meistens Spannungen im Bereich von 0,5 ....50 Volt angelegt. Der beschichtete Formkörper wird dabei als Anode .....haltet. Als Kathode verwendet man zweckmäßig reduktionsstabile Elek-....tronenleiter, wie Nickel Edelstahl, Platin oder Kohlenstoffmaterilien.

....Polymerisation der Monomeren kann auch im Wechselfeld vorgenommen wer-.....Hierzu wählt man zweckmäßig Frequenzen im Bereich vom 50 bis .....000 Hz. Die Stromdichten und Spannungen können im oben genannten · .....ich liegen.

....nach dem erfindungsgemäßen Verfahren hergestellten Verbundstoffe .....nen folgenden Verwendungen zugeführt werden: Gehäuse zur Abschirmung ....romagnetischer Strahlen, Leiterbahnen, Batterielektroden oder Elek-....troden zur chemischen Synthese.

## Beispiel 1

Ein Formkörper aus einem ABS-Polymerisat mit den Ausmaßen 0,5 x 4 x 0,5 cm wird an zwei Oberlächen mit Graphit beschichtet. Hierzu wird eine Graphitlösung aufgesprüht und das Lösungsmittel verdampft. Die Schichtdicke beträgt 1 µ. Der so behandelte Formkörper wird in eine wäßrige Lösung eingetaucht und als Anode geschaltet. Die Lösung enthält außer Wasser 2 ml Pyrrol, bezogen auf 100 ml Wasser und 5,8 NaCl, ebenfalls auf 100 ml Wasser bezogen. Als Kathode wurde eine Nickelelektrode gleicher Dimension verwendet. Es wird eine Stromstärke von 0,5 mA angelegt, wodurch eine Spannung von 2 Volt vs SCE resultiert. Nach 120 Minuten wird abgeschaltet und der Probekörper aus der Lösung genommen, gewaschen und 8 Stunden bei 60°C getrocknet. Der Formkörper ist zweiseitige über die Kanten mit einer 20 µm dicken Schicht von Polypyrrol beschichtet.

## Beispiel 2

Ein Formkörper aus einem ABS-Polymerisat mit den Ausmaßen 1,3 x 4,3 x 0,2 wird mit Chromschwefelsäure gebeizt und einseitig mit Graphit überzogen. Der Formkörper wird gewaschen und getrocknet und wie in Beispiel 1 beschrieben, in eine wäßrige Kochsalzlösung getaucht udn als Anode geschaltet. Es wird eine Stromstärke von 28 mA angelegt, so daß eine Spannugn von 9,0 Volt vs SCE vorliegt. Nach 90 Minuten wird die Probe entnommen, gewaschen und getrocknet. Der Formkörper ist einseitig mit einer Schicht von Polypyrrol einer Dicke von 10 µm beschichtet.

In gleicher Weise wird ein Formkörper der gleichen Dimension aus Standardpolystyrol an einer Oberfläche gebeizt und wie beschrieben mit einer Schicht aus Polypyrrol versehen.

## Beispiel 3

Es wurde wie in Beispiel 1 gearbeitet, jedoch die in der Tabelle angegebenen Formkörper, Monomeren, Lösungsmittel und Leitsalze verwendet.

Tabelle

| Formkörper aus | Leitsalz | Lösungsmittel | Monomeres |
|---|---|---|---|
| Polystyrol | $LiClO_4$ | Wasser | Pyrrol |
| Blockpolymerisat aus Styrol und Butadien | KCl | Wasser | Pyrrol |
| Copolymerisat aus Styrol und Acrylnitril | $NaClO_4$ | Wasser | Pyrrol |
| Polyethylen | $M(CH_3)PF_6$ | Acetonitril | Methylthiophen |
| PVC | $N(C_3H_7)PF_4$ | Acetonitril | Carbazol |
| Polytetrafluorethylen | $LiBF_4$ | Propylencarbonat | Thiophen |
| Polypropylen | $LiClO_4$ | Propylencarbonat | Thiophen |

Es wurden Schichtdicken von 1 bis 20 µm erzielt.

0172518

## Patentansprüche

1. Verfahren zur Herstellung von Verbundstoffen aus nichtleitenden Polymeren und intrinsisch leitfähigen Polymeren, dadurch gekennzeichnet, daß man die Oberfläche eines Formkörpers eines nichtleitenden Polymeren mit einem leitfähigen Stoff beschichtet und/oder einen Formkörper eines nichtleitenden Polymeren, der einen leitfähigen Stoff in feinteiliger Form enthält, in eine Lösung eintaucht, die ein anodisch oxidierbares und polymerisierbares Monomeres und Leitsatz enthält, den Formkörper als Anode schaltet und das Monomere anodisch polymerisiert.

2. Verfahren nach Anspruch 1, dadurch gekennzeichnet, daß der Formkörper aus einem ABS- oder einem ASA-Polymerisat besteht.

3. Verfahren nach Anspruch 1 und 2, dadurch gekennzeichnet, daß man die Oberfläche des Formkörpers mit Metallen, Ruß, Graphit oder einem anorganischen Halbleiter beschichtet.

4. Verfahren nach Anspruch 1 und 2, dadurch gekennzeichnet, daß man als anodisch oxidierbares und polymerisierbares Monomeres eine Verbindung aus der Klasse der Pyrrole oder Thiophene verwendet.

5. Verfahren nach Anspruch 1 und 2, dadurch gekennzeichnet, daß man als Lösungsmittel Wasser oder ein Wasser enthaltendes Lösungsmittelgemisch verwendet.

i.A. Kurz